# EUROPEAN PATENT SPECIFICATION

(11) **EP 1 549 961 B1**
(45) Date of publication and mention of the grant of the patent: **13.06.2007**
(21) Application number: 02807885.5
(22) Date of filing: 02.10.2002
(51) Int. Cl.: G01R 1/073

(54) **TEST HEAD POSITIONING APPARATUS**
TESTKOPFPOSITIONIERUNGSVORRICHTUNG
APPAREIL DE POSITIONNEMENT DE TETE D'ESSAI

(43) Date of publication of application: 06.07.2005
(73) Proprietor: inTEST Corporation, Cherry Hill, NJ 08003 (US)
(72) Inventor: MUELLER, Christian, 83026 Rosenheim (DE)
(74) Representative: Gassenhuber, Andreas
(86) International application number: PCT/IB2002/004064
(87) International publication number: WO 2004/031782

(56) References cited:
- WO-A-00/41536
- WO-A-01/04644
- WO-A-01/64389
- WO-A-02/25292
- DE-A- 3 617 741
- DE-A- 4 436 045
- US-A- 4 589 815
- US-A- 4 705 447
- US-A- 5 149 029
- US-A- 5 931 048
- US-B1- 6 448 797
- PATENT ABSTRACTS OF JAPAN vol. 1999, no. 09, 30 July 1999 (1999-07-30) -& JP 11 094904 A (ADVANTEST CORP), 9 April 1999 (1999-04-09) -& US 6 271 657 B1 (NEMOTO) 7 August 2001 (2001-08-07)

## Description

### FIELD OF THE INVENTION

The present invention relates, in general, to positioning systems for test heads for testing electronic components, and more specifically, to positioning systems for providing vertical compliant motion of test heads for testing electronic components.

### BACKGROUND OF THE INVENTION

In the automatic testing of electronic components such as integrated circuits (IC's), it is customary to use a system that includes a "handling apparatus" to handle the item to be tested. The handling apparatus may be a packaged device handler, a wafer prober or other handling equipment; the type of handling apparatus used may depend upon the stage of manufacturing or development where the testing occurs. The handling apparatus brings each device under test (DUT) in turn to an included test site where it is connected to a test socket, probe card, or the like, where it may be electronically tested.

The electronic testing itself is provided by a large and elaborate automatic testing system, which includes a test head. The test head is often connected to a mainframe by means of a cable which carries electrical power, signals, and possibly other desirable items such as coolant for the test head. The test head provides electrical power and test signals to the DUT. The test head is often densely packaged with precision, high-speed electronic circuits in order to achieve the accurate high speed testing of the sophisticated devices. Thus, the test head is very heavy, on the order of 40 to 1000 kilograms or more. In very sophisticated test heads, the circuitry may require that coolant be pumped through the test head, which contributes significantly to the test head's weight, as well as the weight and resiliency of the cable.

When testing, the test head must be located as close as possible to the handling apparatus's test site in order to minimize signal degradation. Accordingly, the test head may be required to dock with the handling apparatus. A test head positioning system may be used to position the test head with respect to the handling apparatus and may be designed to facilitate flexible docking and undocking of a test head with a variety of handling apparatuses. A test head positioning system may also be referred to as a test head positioner or test head manipulator. Test head positioning systems have been described in numerous patents, and certain patents of interest will be mentioned later.

Docking is well known and documented in the patent literature. For example, U.S. patent 4,589,815 (due to Smith) describes an early docking system whose principles are still in general use. Additionally, WIPO International Publications WO 02/25292 A2 (Ny et al) and WO 01/64389 A2 (Holt et al), provide more general discussions of contemporary docking and include several further references. Some pertinent concepts are summarized where appropriate in the following discussions.

It is often desirable to dock a given test head with different handling apparatuses from time to time. For example, testing may be performed with a certain packaged device handler for a time, and then it may be desired to change to another packaged device handler. In other situations, it may be desired to change between a wafer prober and a packaged device handler. In such cases the test head is undocked from the original handling apparatus which is then moved out of the way. The new handling apparatus is then moved into place, and the test head is docked with it. Also, it is often desirable to move the test head away from a handling apparatus to perform maintenance. Thus, it may be required to easily dock and undock the test head with a variety of different handling apparatuses. The location and orientation of test sites varies from one handling apparatus to the next. It may be oriented horizontally upwards (DUT up), horizontally downwards (DUT down), vertically, or at an arbitrary angle. Thus, depending upon the apparatus being docked with, the test head may have to be generally moved upwards, downwards, horizontally, or at an arbitrary angle. Accordingly, a wide range of motion is desirable in a test head positioning system. For example, a requirement for a vertical range of motion of approximately one meter or more is not uncommon.

The test head positioning system is a mechanical device that allows an operator to bring an automatic test equipment test head with a mass of hundreds of kg or more into proximity with a handling apparatus and to allow the test head to be docked with it. As semiconductor chips have and continue to become faster and more complex, the size and weight of test heads have continually grown larger. What is more, the size, weight, and resiliency of the cable that connects the test head to the automatic test equipment cabinet have correspondingly increased. These factors have created demand for test head positioning systems with both an increased load carrying capacity and an increased range of motion. When the test head is docked with the handling apparatus, hundreds or thousands of delicate electrical contacts must be precisely aligned and mated to enable testing signals and power to be transferred between the DUT and the test head. Overall it is very challenging to design an apparatus that can freely move loads approaching many hundreds of kilograms with the precision needed to mate hundreds or thousands of individual delicate electrical contacts.

As discussed in more detail in the previously mentioned WIPO publications, there are two general categories of docking: actuator driven and manipulator driven. Actuator driven docking, introduced in the '815 patent, is by far the most widely accepted and used category. Actuator driven docking requires that complementary alignment features, such as (but not limited to) alignment pins and receptacles, be attached respectively to the test head and handling apparatus. Also an actuation mechanism, such as (but not limited to) lever driven cams, attached to one of the test head and handling apparatus, which engages actuation structures, such as (but not limited to) cam followers, attached to the other of the test head and handling apparatus, is provided. Briefly, docking requires that the test head first be positioned so that it is in close proximity (e.g., within approximately one cm) to the handling apparatus and in approximate alignment with the test site. The system is then said to be in a "ready to dock" position. The test head is moved closer to its docked position until the actuation mechanism comes into initial engagement with the actuation structures. Often, coarse alignment features are provided to ensure that this motion is done accurately and without damaging the delicate contacts. The system is now said to be in a "ready to actuate" condition. The actuator may now be operated, and it affects further docking motion, drawing the test head into full electrical contact with the test site in a "fully docked" condition. Typically, fine alignment features are provided to ensure that the contacts are aligned precisely within desired tolerances. The actuator develops the necessary force to overcome system friction and contact force. Depending upon the system, the actuator may be either powered or manual. The relatively small motions of the test head in being moved from a position close to ready to dock to fully docked may be referred generically as "fine-tuning" the position of the test head.

Thus, it is apparent that the manipulator must support the mass of the test head while allowing the actuator to draw the test head into a fully docked position. During fine-tuning and dock actuation, the general trajectory of the test head is dependent upon the orientation of the handling apparatus's test site. Also, during dock actuation, fine alignment of the test head may occur, requiring small motions in several directions. Thus, while supporting the mass of the test head, the test head positioning system desirably allows the test head to freely move compliantly or in a substantially weightless manner in several degrees of freedom. That is, the force required to position the load is substantially less then that required to support the load. Although compliant motion in all six degrees of freedom is often preferred, test head positioning systems with fewer degrees of freedom are known. Also, during testing the handling apparatus may generate mechanical vibrations whose energy must be absorbed by the system. Accordingly, in order that the vibrations are not absorbed in a damaging fashion by the delicate electrical contacts, users often prefer to maintain the test head in a compliant state while testing.

Test head positioning systems that maintain the test head in a substantially weightless condition throughout their entire range of motion are well known. Such systems allow an operator to grasp the test head (or handles attached to it) and manually move it through space. Compliant motion for actuator driven docking is inherently included. Thus, for docking, an operator manually positions the test head to the ready to actuate position and then operates the actuator. U.S. patent 4,529,942 (Smith) discloses a test head positioner, which provides such free motion in six degrees of freedom. To achieve this, counter weights provide free motion in the vertical direction; rotational axes that may not be in the horizontal plane are passed essentially through the center of gravity of the test head; and low friction bearings are used throughout.

U.S. patents 4,589,815, 4,705,447, and 5,149,029 (all due to Smith) disclose an alternative system that uses a pressurized cylinder and piston in lieu of counter weights to provide substantially weightless motion throughout the vertical range of travel. A pneumatically-operated, telescoping vertical column where the movable portion is effectively the pneumatic piston is described. In this arrangement, maintaining constant pneumatic pressure provides a counterbalancing force to the weight of the test head and cable. The test head is attached to the piston through an appropriate support structure. As the test head is moved vertically, the piston moves correspondingly within the cylinder. Compressed air or other suitable fluid is injected into the cylinder, and a regulator controls its pressure such that it maintains a force on the piston that corresponds to the weight of the load carried by the piston. The regulator maintains this constant pressure as the test head load is moved, thus providing a substantially weightless condition. The system is further arranged so that the cylinder and piston form a telescoping vertical column whose height corresponds to the height of the test head.

In certain situations and particularly as test heads have become larger and more massive, it has become desirable to provide drive units, such as a motors, hand cranks or the like to drive selected axes in a test head positioning systems. Often, a drive unit is desired first of all for the vertical axis. In use with actuator driven docking, the drive unit would drive the axis until a ready to dock or ready to actuate position is achieved. The test head may then be moved compliantly with respect to the drive unit in order for it to be docked. In a telescoping pneumatic system such as described in the '815 patent (see above) this could conceivably be achieved by controlling the air pressure in the cylinder as in an automobile lift; however, it could be difficult to adequately control. A more practical approach is disclosed in WIPO International Publication Number WO 00/41536 (Holt et al). This discloses a technique to add drive motor units to vertical and other axes of a fully counterbalanced manipulator in a manner that preserves compliance.

Further, as test heads have become larger and more massive their positioning systems have correspondingly become larger and taller, particularly as vertical stroke requirements have increased. Thus, telescoping vertical structures have become desirable to facilitate shipping, moving through doorways, maintenance; etc. Also as test heads have become more and more massive, it has become less and less desirable to use counterweights, which must be somewhat greater than the combined mass of the test head, its support structure, and the cable it supports. An all-pneumatic system, such as described in the '815 patent, is limited in stroke; and, as previously mentioned, accurate positioning, is difficult to achieve. US patent 5,931,048 (Slocum et al) discloses a telescoping test head manipulator driven by an electrical motor and screw mechanism. No counter weights are used and the screw mechanism supports the load. Vertical compliance is provided by a pneumatic mechanism placed between the base and the telescoping vertical column. Thus, the vertical compliance mechanism requires valuable space beneath the column, which could limit the vertical reach and/or be limited in overall compliant range. Springs and the like provide compliance in other axes. US patent 5,949,002 (Alden) describes the same manipulator as in the '048 patent but with a load cell and sophisticated electronic control system arranged to provide compliance and replace the pneumatic scheme. Reportedly, this makes the system more adaptable to variable or changing load conditions.

Still further prior art has been reported. WIPO publication WO 01/64389 A2 (Holt et al) discloses a telescoping manipulator with a ball screw driven vertical axis. The load is supported by the driven screw. A vertical compliance mechanism is provided that includes a mechanical advantage device (such as a ball screw) and counter weights having a mass that is a fraction of the mass of the load. WIPO publication WO 02/25292 A2 (Ny et al) discloses techniques involving force sensors, force generators, and sophisticated controls to provide balance and compliance in a variety of possible driven axes to facilitate docking.

A related disclosure is German patent 44 36 045 A1 in which a lifting device having a ball spindle shaft driven by an electrical motor that can move a carriage carrying a work piece or other apparatus in the vertical direction. Here the carriage operates using magnets in conjunction with a cylinder. This technology has not been applied to test head positioning systems, and it does not appear to offer compliance.

An improved telescoping test head positioning system having a driven vertical axis with compliance for docking is desirable. For maintenance and adaptation simplicity and minimal cost, it should not be dependent upon load cells and other sensors combined with sophisticated control systems. To minimize overall weight, it should not use counterweights. The vertical drive should preferably be electrically controlled for smooth operation and adaptable to either operator push button control or computer control. The compliance means should offer an acceptable range of compliant motion and be readily adjustable to meet a range of conditions and applications.

### SUMMARY OF THE INVENTION

In an exemplary embodiment of the present invention, a positioning apparatus for positioning a test head for testing electronic components is provided. The positioning apparatus includes an outer cylinder and a support coupled to the outer cylinder for supporting the test head. The positioning apparatus also includes a piston arranged within said outer cylinder such that the piston and the outer cylinder define a fluid compartment within the outer cylinder. The positioning apparatus also includes a pressure regulator for maintaining a pressure within the fluid compartment such that the test head may be suspended in a substantially weightless position, the substantially weightless position being adjustable in a vertical direction. The positioning apparatus also includes a lifting device for raising and lowering the outer cylinder. The lifting device includes a threaded drive mechanism coupled to the piston. The positioning apparatus also includes a drive apparatus for operating the threaded drive mechanism to move the test head to a predetermined position.

In another exemplary embodiment of the present invention, a positioning apparatus for positioning a test head for testing electronic components is again provided. The positioning apparatus includes a drive mechanism for moving the test head in a vertical direction. The positioning apparatus also includes a pneumatic compliant coupling mechanism coupled to said drive mechanism. The pneumatic compliant coupling mechanism supports the test head in a substantially weightless condition and provides a range of motion to the test head in the vertical direction. The pneumatic compliant coupling mechanism is positioned above and secured to the drive mechanism such that the drive mechanism moves the pneumatic compliant coupling mechanism when moving the test head in the vertical direction.

In another exemplary embodiment of the present invention, a method of positioning a test head for testing electronic components is provided. The method includes providing flow of a fluid into a fluid compartment coupled to the test head. The method also includes mechanically moving the test head to a desired position in a vertical direction using a drive mechanism. The method also includes fluidly suspending the test head in a substantially weightless condition by maintaining a fluid pressure in the fluid compartment positioned between the test head and the drive mechanism.

### BRIEF DESCRIPTION OF THE DRAWINGS

The invention is best understood from the following detailed description when read in connection with the accompanying drawings. It is emphasized that, According to common practice, the various features of the drawings are not to scale. On the contrary, the dimensions of the various features are arbitrarily expanded or reduced for clarity. Included in the drawings are the following figures:
Figure 1 is a perspective view of a positioning apparatus carrying a test head in accordance with an exemplary embodiment of the present invention;
Figure 2 is a perspective view of a positioning apparatus carrying a test head that is docked to a handling apparatus in accordance with an exemplary embodiment of the present invention;
Figure 3 is a front cross sectional view of two cylinders with a lead screw included in a positioning apparatus in accordance with an exemplary embodiment of the present invention;
Figures 4 through 6 are front cross sectional views of an outer cylinder set in different height positions in relation to an inner cylinder included in a positioning apparatus in accordance with an exemplary embodiment of the present invention;
Figure 7 is a pneumatic connection diagram of a pressure regulation device in accordance with an exemplary embodiment of the present invention;
Figure 8 is a perspective view of a portion of a positioning apparatus in accordance with an exemplary embodiment of the present invention;
Figure 9 is a detailed partial perspective view of a cross section of two cylinders and a lead screw included in a positioning apparatus in accordance with an exemplary embodiment of the present invention;
Figure 10 is a partial perspective view of a cross section of two cylinders and a lead screw included in a positioning apparatus in accordance with an exemplary embodiment of the present invention; and
Figure 11 is a perspective view of a base for supporting two cylinders and a lead screw included in a positioning apparatus in accordance with an exemplary embodiment of the present invention.

### DETAILED DESCRIPTION OF THE INVENTION

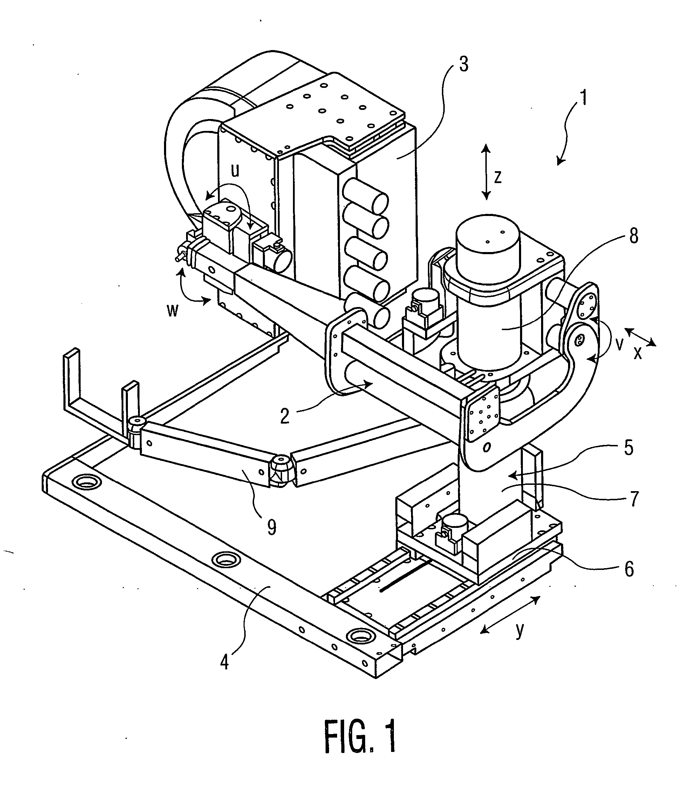

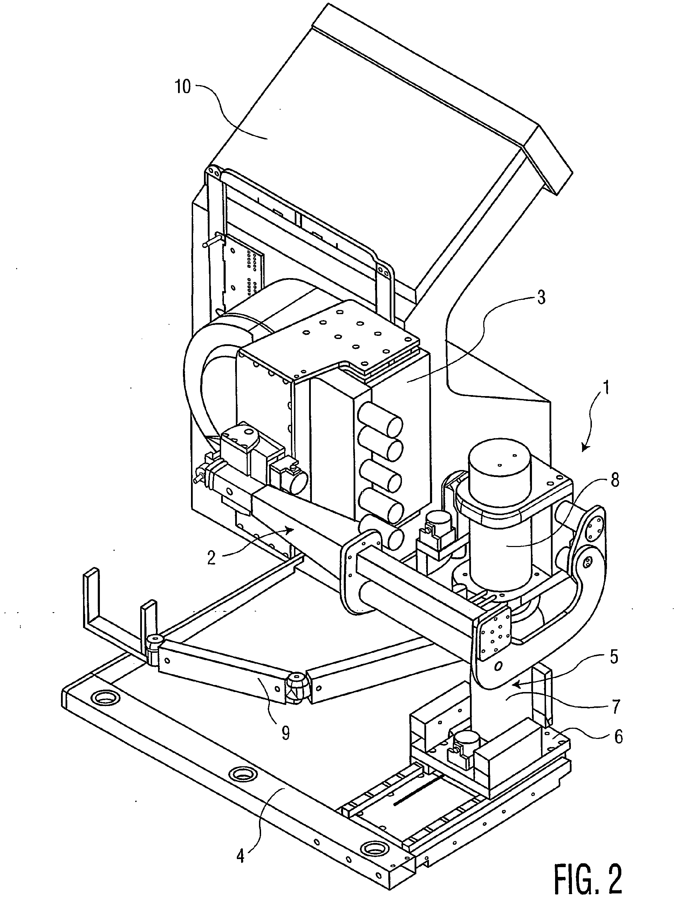

Figures 1 and 2 provide perspective views of a positioning apparatus 1 including a carrier-arm device 2 for supporting a test head 3 for testing electronic components.

Positioning apparatus 1 includes base frame 4 resting on the floor from which a vertical column arrangement 5 extends upward. Column arrangement 5 can be moved in the y-direction via a carriage 6. Carrier-arm device 2 can be moved in relation to column arrangement 5 in the x-direction. Column arrangement 5 includes a bottom tubular inner cylinder 7 and a top tubular outer cylinder 8 that is placed on inner cylinder 7 such that cylinders 7 and 8 are telescopically engaged with one another. By adjusting the height of outer cylinder 8 in relation to inner cylinder 7, carrier-arm device 2, which is attached to outer cylinder 8 (and test head 3) can be adjusted in height, i.e., in the z-direction. Moreover, carrier-arm device 2 may swivel about a horizontal axis in the v-direction. Test head 3 may swivel about a horizontal axis in the w-direction and about a vertical axis in the u-direction. Test head 3 is attached at the free end of carrier-arm device 2. Using this arrangement, test head 3 can be manipulated in all directions; i.e., with six degrees of freedom. Cable hanger 9, for supporting cables associated with test head 3 and/or positioning apparatus 1, is also shown in Figures 1 and 2.

Figure 2 again illustrates positioning apparatus 1 including carrier-arm device 2 for supporting test head 3. In Figure 2, test head 3 is docked to handing apparatus 10. Electronic components are brought to test head 3 via handling apparatus 10 in such a manner that they can be tested with regard to their electrical characteristics: As such, precise positioning of test head 3 with respect to handling apparatus 10 is desirable.

The alignement of test head 3 with respect to handling apparatus 10 may be accomplished, for example, using alignment features such as a centering pin and/or dowel screws, which extend, for example, from a frame provided on handling apparatus 10 in the direction of test head 3 and are introduced into the respective openings or receptacles, which are located on test head 3 or a frame attached to test head 3.

Docking is typically accomplished by driving test head 3 via a corresponding movement in the u-, v-, w-, x-, y- and/or z-directions as precisely as possible into the desired ready to dock position in the immediate vicinity of handling apparatus 10. If necessary, fine0tuning motion into the ready to actuate position may then be accomplished manually, for the most part, until the dock actuation components engage with one another. The dock actuator may then be utilized to draw test head 3 into a fully docked position as previously described.

In this context, the vertical fine-tuning alignment of test head 3, i.e., a fine-tuning adjustment in the z-direction, can be carried out in a very simple and precise way using positioning apparatus 1 of the present invention, as is explained in greater detail below.

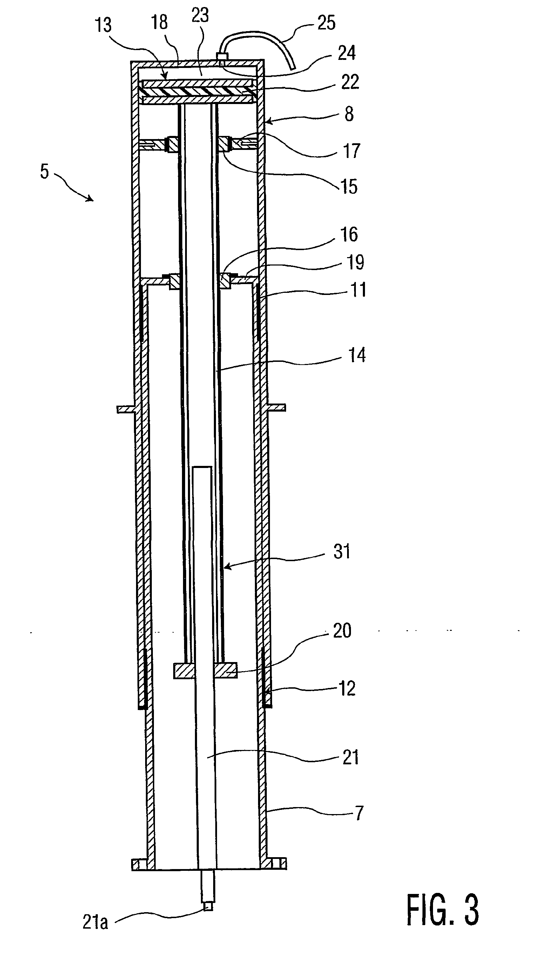

Vertical column arrangement 5, including inner cylinder 7 and outer cylinder 8, is illustrated in greater detail in Figure 3. Outer cylinder 8 is arranged so that it can slide on inner cylinder 7, thereby providing a telescoping alignment configuration. To achieve the desired sliding characteristics, two slide bushings 11 and 12 are provided between cylinders 7 and 8. Top slide bushing 11 is located in the vicinity of the top end of inner cylinder 7, while bottom slide bushing 12 is located in the vicinity of the bottom end of outer cylinder 8.

Piston 13 is arranged in the top end section of outer cylinder 8, from which central lifting rod 14 extends vertically downward. Lifting rod 14 is longitudinally movable within guide bushings 15 and 16. Top guide bushing 15 is held by horizontal retaining webs 17, which extends radially inward from the interior perimeter wall of outer cylinder 8 and are fastened in place on the interior perimeter wall. Retaining webs 17, and thus guide bushings 15, are located in the vicinity of the top end area of outer cylinder 8 at a distance from the top end face 18 of cylinder 8, which, in the exemplary embodiment shown in Figure 3, corresponds to approximately 11 % of the total length of cylinder 8. Of course, this distance can vary in accordance with the desired range of piston travel and be, for example, 5 to 20% of the length of cylinder 8.

Bottom guide bushing 16 is set in the center of top end face 19 of inner cylinder 7. Lifting rod 14 thus extends downward into the inner cylinder 7. Moreover, the cross-section of lifting rod 14 and, thus, also the openings of guide bushings 15, 16 may be square in order to prevent a turning of lifting rod 14 inside column arrangement 5. Attached at the bottom end of lifting rod 14, which is near the bottom end of inner cylinder 7, is a lead screw nut 20.

In order to be able to move lifting rod 14 (and with it piston 13, outer cylinder 8, carrier-arm device 2, and test head 3) in the vertical direction, a lead screw 21 is provided that extends down into inner cylinder 7 and is engaged with lead screw nut 20. Lifting rod 14 may be of a hollow design, so that lead screw 21 can extend into lifting rod 14. Lead screw 21 extends downward past the lower end of inner cylinder 7 and is coupled to a drive motor (not shown in Figure 3). As shown in Figure 3, lead screw end 21a extends below inner cylinder 7. By turning lead screw 21 (using a drive motor), lead screw nut 20, along with lifting rod 14, moves vertically along stationary lead screw 21 upwardly or downwardly. Piston 13, lifting rod 14, lead screw nut 20 and lead screw 21 are part of a lifting device 31.

Piston 13 has a radially projecting sealing collar 22, which seals piston 13 against the inner wall of outer cylinder 8. A sealed fluid-holding compartment 23 is thereby provided between piston 13 and top end face 18 of outer cylinder 8. Fluid-holding compartment 23 is connected by an opening 24, which is located in top end face 18, to a fluid line 25, so that fluid (e.g., compressed air) can be introduced into, and diverted from, fluid-holding compartment 23.

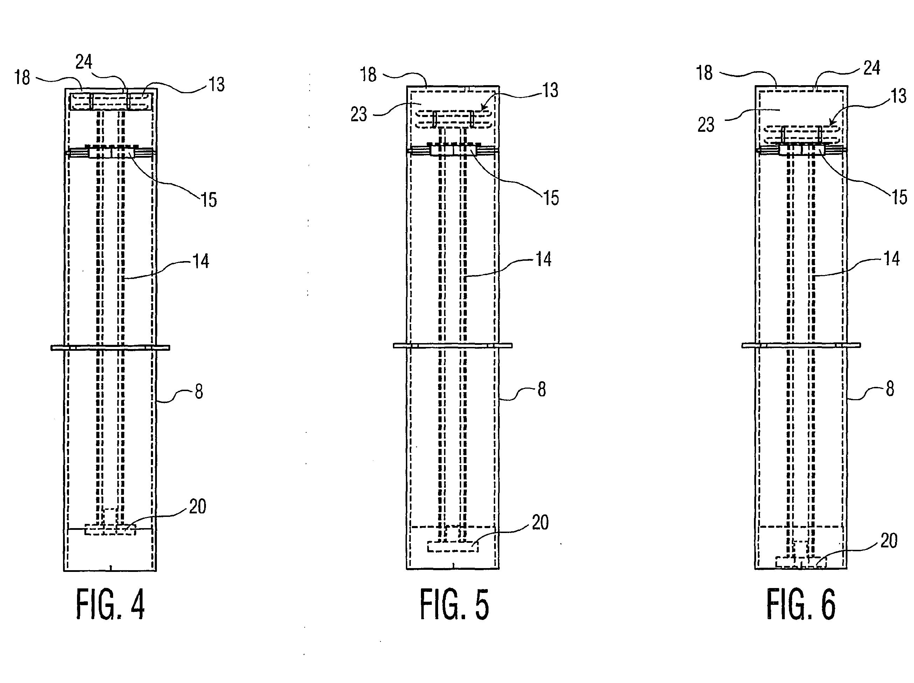

If fluid is fed to fluid-holding compartment 23, then outer cylinder 8 is pressed upward, with piston 13 remaining stationary. Figures 4 through 6 illustrate three different positions of outer cylinder 8 with respect to piston 13. For example, Figure 4 illustrates a position in which outer cylinder 8 is lowered to a maximum extent in relation to piston 13, so that piston 13 pushes on top end face 18. Figure 5 illustrates a raised position of cylinder 8. Figure 6 illustrates the maximum raised position of cylinder 8 in relation to piston 13. In order to reverse the process and lower cylinder 8 in relation to piston 13, fluid is released from fluid-holding compartment 23, whereupon cylinder 8 drops in relation to piston 13 because of the weight of support arm device 2, which is attached to cylinder 8, and test head 3.

As such, at the start of the docking operation, if there is an inadequate supply of air in fluid-holding compartment 23, air may be injected into fluid-holding compartment 23 to compensate for the weight of test head 3 (and associated system components), thereby suspending test head 3 in a substantially weightless condition. An operator could then move test head 3 to a central position within the range of motion of piston 13 (e.g., Figure 5), or any other desired position.

As explained in more detail below, during the docking of test head 3 to handling apparatus 10, it is often desirable to maintain test head 3 in a substantially weightless condition that may be adjusted vertically without excessive force such that fine adjustments may be made to the position of test head 3. This substantially weightless condition may be referred to as being in a compliant condition, where the test head may be compliantly moved along a vertical axis in a certain range of motion, without excessive external force. For example, the position of outer cylinder 8 in Figure 5 indicates that test head 3 is in a compliant condition in that the cylinder may travel up and down (towards the positions shown in Figures 4 and 6) along a vertical range of motion.

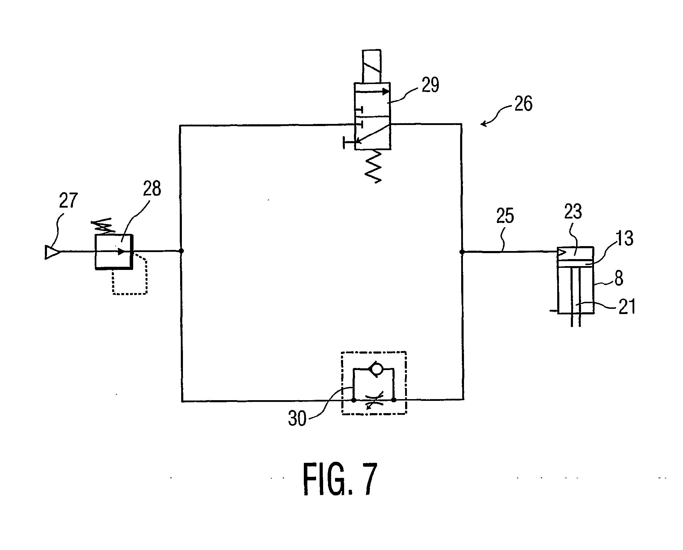

In order to be able to carry out a fine-tuning adjustment of the vertical position of test head 3 in a simple manner, and without excessive force, test head 3 is held by positioning device 1 at approximately the desired height in a suspended state such that a relatively small force may be used to adjust the height in a precise manner within certain limits. For this purpose, a pressure regulation device 26, which is illustrated in Figure 7, is provided. Pressure regulation device 26 regulates the fluid flow and pressure between a pressure generation device 27 and fluid-holding compartment 23. For this purpose, pressure generation device 27 is connected to a pressure fine-tuning regulator 28, which regulates the fluid pressure in a very precise manner such that a specific pressure target value may be maintained. In the event of a drop in pressure in fluid line 25, fluid may be immediately fed to fluid-holding compartment 23, while in the event of an increase in pressure above the target value, fluid may be immediately diverted out of fluid-holding compartment 23.

As shown in Figure 7, the fluid supplied by pressure generation device 27 first flows through an electromagnetically controlled 3/2-way valve 29, which is switched to flow through in the activated state. This 3/2-way valve 29 has a spring return so that in the event of a power failure, distribution valve 29 is pressed back into a position in which the return flow from fluid-holding compartment 23 is blocked.

Provided parallel to the 3/2-way valve 29 is a one-way restrictor 30, which also prevents a return flow of the fluid from fluid-holding compartment 23 and, beyond that, may permit a slight manual raising of the test head 3 for positioning purposes. Downstream of 3/2-way valve 29 and one-way restrictor 30, the two branch lines are brought back together and form fluid line 25, which opens out into fluid-holding compartment 23 of outer cylinder 8.

If test head 3 is manually raised somewhat for the purpose of fine-tuning adjustment (when test head 3 is in a substantially weightless condition) of the elevation position, then the pressure in fluid-holding compartment 23 is reduced in accordance with the lifting force. Pressure regulation device 26 recognizes this drop in pressure and increases the fluid pressure by feeding additional fluid into fluid-holding compartment 23 until the original target pressure is reached again. With a continuing slight lifting of test head 3, outer cylinder 8, and thus test head 3, can be moved upward continually and with little force until outer cylinder 8 has reached the position shown in Figure 6 in which piston 13 presses against retaining webs 17 or guide bushing 15. Alternatively, if test head 3 is pressed downward in the process of fine-tuning adjustment (when test head 3 is in a substantially weightless condition), the pressure in fluid holding compartment 23 increases. The pressure control device 26 recognizes this pressure increase and diverts fluid out of fluid-holding compartment 23 until the original target value is reached again. By continuous, light downward pressure, test head 3 can be moved downward in this manner without exerting excessive force, until outer cylinder 8 has reached the position shown in Figure 4.

In this way, a suspended or "floating" system can be provided for easy, compliant manual fine-tuning adjustment of the height position of test head 3.

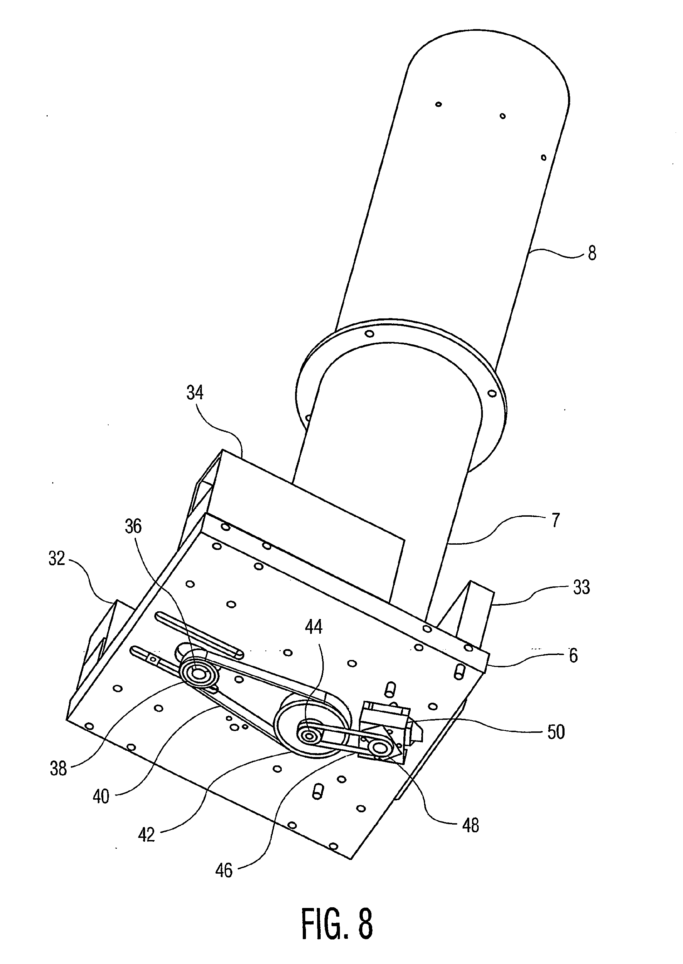

Figure 8 is a perspective view of a portion of positioning apparatus 1. As described above, outer cylinder 8 and inner cylinder 7 are telescopically engaged with one another. Inner cylinder 7 is mounted on carriage 6. Additional components may be mounted on carriage 6, for example, power supply units 32 and 34, and control electronics housing 33, as shown in Figure 8. Figure 8 also provides a perspective view of the components of the system housed beneath carriage 6. A motor (not visible in Figure 8) is mounted on the top side of carriage 6. As shown in Figure 8, motor shaft 36 extends beneath carriage 6. Motor shaft 36 is coupled to motor pulley 38.

Lead screw 21 is coupled to encoder drive pulley 44. Lead screw pulley 42 may be rigidly secured to lead screw 21, or optionally may be coupled to lead screw 21 through encoder drive pulley 44 (e.g., a stepped pulley including lead screw pulley 42 and encoder drive pulley 44). Lead screw pulley 42 is connected to motor pulley 38 through drive belt 40. As such, when motor shaft 36 rotates, motor pulley 38 also rotates, thereby driving drive belt 40. Drive belt 40 rotates lead screw pulley 42, thereby operating lead screw 21. As such, by operating the motor in either direction, lead screw 21 can be operated to raise or lower piston 13 as described above, thereby raising or lowering test head 3.

Encoder drive pulley 44 is connected to encoder pulley 48 through timing belt 46. As such, when encoder drive pulley 44 rotates so does encoder pulley 48. Encoder 50 can retrieve data from encoder pulley 48, for example, timing data, number of rotations, etc. This data can be translated into information related to the operation of lead screw 21 and the test head positioning system in general, for example, the vertical position of test head 3). As such, encoder 50 can provide feedback data to a computer or control system. Although the sensing device is this exemplary embodiment of the present invention is an encoder, any type of sensing device may be used, for example, a conventional position sensor (e.g., a string pot).

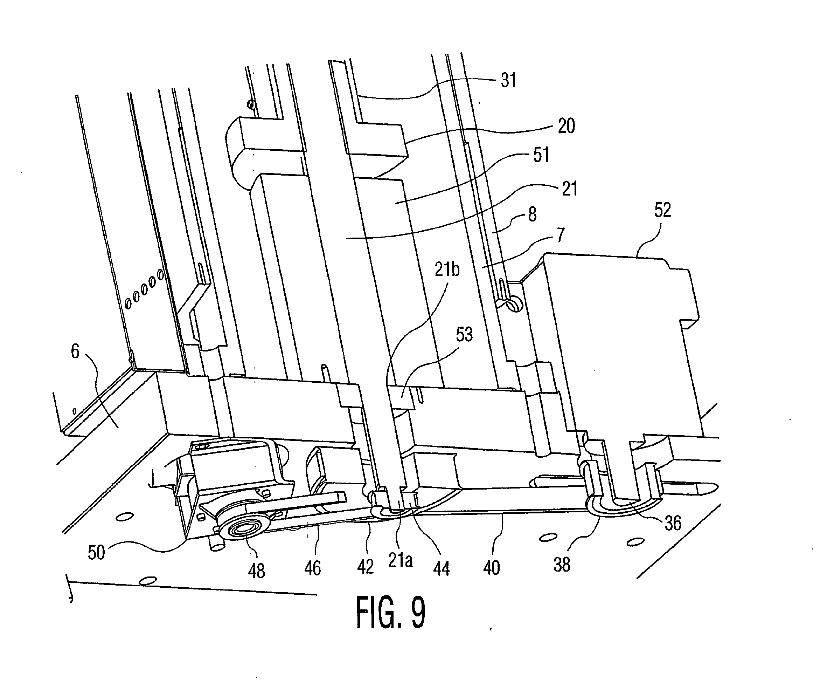

Figure 9 is a detailed partial perspective view of a cross section of cylinders 7 and 8. Various elements of lifting device 31 are also at least partially visible in Figure 9, including lead screw 21 and lead screw nut 20. Beneath lead screw nut 20 is stop 51. Stop 51 may be optionally included for preventing mechanical motion of ball screw nut 20 below a predetermined position. Lead screw 21 includes shoulder 21b. Shoulder 21b is journaled by bearing 53.

Motor 52 is also shown mounted on carriage 6 in Figure 9. Motor shaft 36 extends from motor 52, below the lower surface of carriage 6. Encoder 50, encoder pulley 48, timing belt 46, encoder drive pulley 44, lead screw pulley 42, drive belt 40, and motor pulley 38 are also shown in the cross sectional view illustrated in Figure 9. As shown in Figure 9, lead screw end 21a is coupled to encoder drive pulley 44.

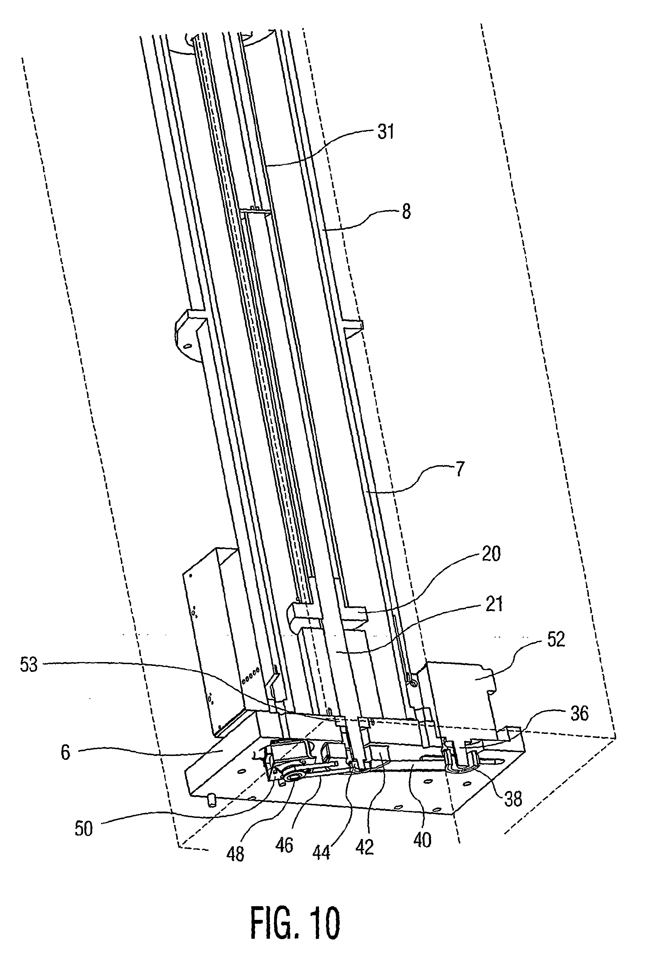

Figure 10 is a partial perspective view of the positioning system, including cylinders 7 and 8, and lifting apparatus 31. As previously described, lifting apparatus 31 includes lead screw 21 and lead screw nut 20. Motor 52 is again shown mounted on carriage 6, with motor shaft 36 extending below the lower surface of carriage 6. As in Figure 9, encoder 50, encoder pulley 48, timing belt 46, encoder drive pulley 44, lead screw pulley 42, drive belt 40, and motor pulley 38 are also shown in the cross sectional view illustrated in Figure 10.

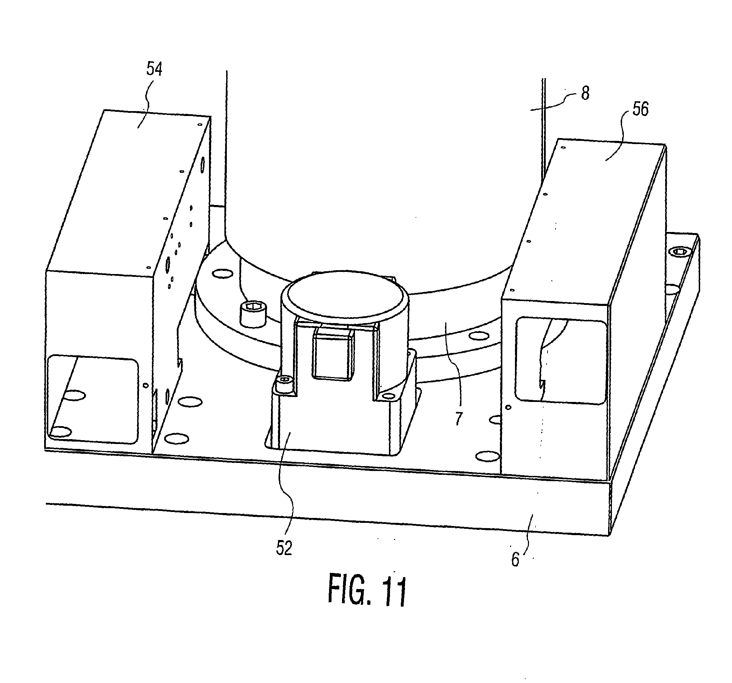

Figure 11 is a perspective view of an upper portion of carriage 6. Cylinders 7 and 8 are telescopically engaged with one another, and mounted on carriage 6. Motor 52 is also mounted on carriage 6. Additionally, power supply units 54 and 56 are shown on either side of motor 52.

As such, the present invention provides a positioning apparatus 1 that permits a docking of a test head 3 to a handling apparatus 10 in a simple, safe and effective manner.

As indicated above, in an exemplary embodiment, the present invention provides a positioning apparatus that includes an inner cylinder 7 telescopically engaged with an outer cylinder 8. A lifting apparatus 31 includes a piston 13 that is arranged inside the outer cylinder 8, where outer cylinder 8 is movable in relation to piston 13. The pressure in the fluid-holding compartment 23 can be regulated such that outer cylinder 8, together with carrier-arm apparatus 2 and test head 3, can be brought into a suspended position that is height-adjustable in relation to the piston 13.

Through the operation of positioning apparatus 1, test head 3 is held at a certain height in a suspended or floating state. In this exemplary embodiment, the height position of test head 3 is maintained as long as no outside force is applied to test head 3 or carrier-arm device 2. If, however, an operator or docking actuator attempts to move test head 3 upward or downward when docking in order to bring it into the desired position, then test head 3 moves into the desired vertical position without a substantial exertion of force. The weight of test head 3 and the carrier-arm device 2 in this context is carried and compensated by the fluid present in the fluid-holding compartment.

For example, if the operator attempts to lift test head 3 slightly, then the pressure in the fluid-holding compartment 23 drops by an amount that corresponds to the manual lifting force. Pressure regulation device 26 recognizes this force and increases the pressure in the fluid-holding compartment 23 accordingly, so that the set target pressure is attained again. If, on the other hand, test head 3 is to be lowered, the operator pulls or pushes test head 3 down using a relatively small exertion of force, the pressure in the fluid-holding compartment 23 is increased. The pressure regulation device 26 recognizes the pressure increase and diverts fluid out of the fluid-holding compartment 23 in order to re-attain the originally set target pressure. This lowers test head 3. The force to be manually applied therefore represents a control signal that causes the pressure regulation device 26 to add fluid to or drain fluid from the fluid-holding compartment 23 in order to reproduce the set target pressure value. In this way, test head 3 can be brought into the accurate vertical position that is required for docking without application of substantial force and in a very precise manner.

In an exemplary embodiment of the present invention, lifting device 31 includes lifting rod 14 that is vertically adjustable using lead screw 21 (coupled to lead screw nut 20), and as such, piston 13 is adjustable in height. Lead screw 21 may be of a type that can be implemented in a simple and space-saving manner, for example, lead screw 21 may be arranged to be positioned, and thereby protected, inside the combination of cylinders 7 and 8. Alternatively, instead of a lead screw of this type, other lifting devices are also conceivable for the rough setting of the height position, for example, scissors linkages, hydraulic drives or any other type of lifting mechanism.

In an exemplary embodiment of the present invention, lifting device 31 includes a hollow lifting rod 14 that is height-adjustable by means of a lead screw 21 (coupled to lead screw nut 20), where the lead screw 21 is centrally arranged inside inner cylinder 7, and lead screw 21 may be at least partially inserted into hollow lifting rod 14. Such an embodiment may be produced in a simple and space-saving manner.

In an exemplary embodiment of the present invention, fluid-holding compartment 23 is bound at the top by top end face 18 of outer cylinder 8, and at the bottom by the piston 13. This means that fluid-holding compartment 23 is located at the top end of outer cylinder 8 and piston 13 is sealed against an inner perimeter wall of outer cylinder 8.

In an exemplary embodiment of the present invention, pressure regulation device 26 includes a pressure fine-tuning regulator 28 for maintaining a constant pressure in the fluid line leading to fluid-holding compartment 23. In this fluid line, 3/2-way valve 29 is provided along with one-way restrictor 30 that is connected in parallel to 3/2-way valve 29. In this way, in the event of a power failure, an undesired lowering of test head 3 is prevented. Moreover, during a power failure, test head 3 can also be raised within a certain range of motion manually, in a simple way in order to permit a docking or undocking of test head 3.

As described above, lifting apparatus 31 may be used to provide coarse positioning of test head 3 with respect to handling apparatus 10. For example, lifting apparatus 31 may be used to drive test head 3 to a ready to dock or possibly a ready to actuate position; which were both described earlier. Further, a compliant range of motion provided by the pneumatic equipment may be used to provide a range of motion for precise alignment of test head 3 with respect to handling apparatus 10, with test head 3 in a substantially weightless condition.

Although various exemplary embodiments of the present invention have been described using a lead screw as the drive mechanism, the drive mechanism may be any type of mechanism that drives the outer cylinder, and as such, the test head. For example, the drive mechanism may be a threaded drive mechanism (e.g., a lead screw or a ball screw), a pneumatic drive mechanism, or any other mechanism that is useful for driving a vertical load.

Various exemplary embodiments of the present invention have been described in terms of a vertical axis. For example, the drive mechanism has been described for moving the test head in a vertical direction. Further, the pneumatic compliant coupling mechanism described herein provides compliance in a vertical direction; however, it is contemplated that these features may be applied to other motion axes of the test head. For example, the drive mechanism may drive the test head in any direction other than a vertical direction (e.g., a 45 degree angled direction, a horizontal direction, etc.), and the compliant mechanism may provide compliance in any direction other than a vertical direction. Further, the term weightlessness as described herein is taken to mean that the test head is weightless relative to any external force applied to the test head, and not only gravitational forces (e.g., cables forces, docking forces, etc.).

## Claims

1. A positioning apparatus (1) for positioning a test head (3) for testing electronic components, said positioning apparatus (1) comprising:
a drive mechanism (20, 21) for moving the test head (3) in a vertical direction; and
a pneumatic compliant coupling mechanism (23) coupled to said drive mechanism (20, 21), said pneumatic compliant coupling mechanism (23) supporting the test head (3) in a substantially weightless condition and providing a range of motion to the test head (3) in the vertical direction,
**characterized in that**
said pneumatic compliant coupling mechanism (23) is positioned above and secured to said drive mechanism (20, 21) such that said drive mechanism (20, 21) moves said pneumatic compliant coupling mechanism (23) when moving the test head (3) in the vertical direction.

2. The positioning apparatus of claim 1 wherein said drive mechanism (20, 21) is threaded.

3. The positioning apparatus of claim 1 or 2 wherein said pneumatic compliant coupling mechanism (20, 21) includes a fluid compartment (23) and a pressure regulator for maintaining a pressure within said fluid compartment (23) such that the test head (3) may be suspended in the substantially weightless condition.

4. The positioning apparatus of claim 1 further comprising:
an inner cylinder (7);
an outer cylinder (8) which is placed over the inner cylinder (7) such that it can slide in a longitudinal direction;
a carrier-arm device (2) that carries the test head (3) and is attached to the outer cylinder (8);
a lifting device (31) for raising and lowering the outer cylinder (8);
a fluid-holding compartment (23) being part of the pneumatic compliant coupling mechanism, the fluid- holding compartment (23) being provided inside the outer cylinder (8); and
a pressure generation device (27) that is connected via a fluid line (25) to the fluid-holding compartment (23) and is designed to generate a fluid pressure force directed counter to the weight of the test head (3) and the carrier-arm device (2), wherein
the lifting device (31) includes a piston (13) arranged inside the outer cylinder (8), the outer cylinder (8) can slide in relation to the piston (13) and the pressure in the fluid-holding compartment (23) can be regulated via a pressure regulation device (26) in such a manner that the outer cylinder (8), together with the carrier-arm device (2) and the test head (3), can be brought into a suspended position that is height-adjustable in relation to the piston (13).

5. The positioning apparatus as recited in claim 4, wherein the lifting device (31) comprises a lifting rod that is adjustable in height by means of a threaded drive mechanism and carries the piston (13) at a top end of the lifting rod.

6. The positioning apparatus as recited in either of claim 4 or 5, wherein the lifting device (31) comprises a hollow lifting rod (14) that can be adjusted in height via a threaded drive mechanism, the threaded drive mechanism having a threaded drive centrally arranged inside the inner cylinder (7) that is introduced into the hollow lifting rod (14).

7. The positioning apparatus as recited in any of claims 4 to 6, wherein the fluid-holding compartment (23) is bounded at the top by a top end face of the outer cylinder (8) and at the bottom by the piston (13).

8. The positioning apparatus as recited in any of claims 4 to 7, wherein the pressure regulation device comprises a pressure regulator to maintain a constant pressure in the fluid line leading to the fluid-holding compartment, and in the fluid line a 3/2-way valve and a one-way restrictor are provided and are connected in parallel with one another.

9. The positioning apparatus according to claim 1 further comprising:
an outer cylinder (8);
a support (2) coupled to said outer cylinder (8) for supporting the test head (3);
a piston (13) arranged within said outer cylinder (8), said piston (13) and said outer cylinder (8) defining a fluid compartment (23) being part of the pneumatic compliant coupling mechanism within said outer cylinder (8);
a pressure regulator (28) for maintaining a pressure within said fluid compartment (23) such that the test head (3) may be suspended in a substantially weightless position, said position being adjustable in a vertical direction;
a lifting device (31) for raising and lowering said outer cylinder (8), said lifting device (31) including the drive mechanism (20, 21) coupled to the piston (13); and
a drive apparatus (52) for operating said drive mechanism (20 ,21) to move the test head (3) to a predetermined position.

10. The positioning apparatus of claim 9 wherein said drive mechanism (20, 21) is a threaded drive mechanism.

11. The positioning apparatus of claim 10 wherein said drive mechanism (20, 21) is a lead screw mechanism.

12. The positioning apparatus of claim 9 wherein said fluid compartment (23) is positioned above said drive mechanism (20, 21) such that when said drive mechanism (20, 21) drives said fluid compartment (23) in a vertical direction, the test head (3) is also driven in the vertical direction.

13. The positioning apparatus of claim 9 additionally comprising: a position sensor (50) for detecting a vertical position of the test head (3).

14. A method of positioning a test head (3) for testing electronic components, said method comprising the steps of:
(a) providing flow of a fluid into a fluid compartment (23) coupled to the test head (3);
(b) mechanically moving the test head (3) to a desired position in a vertical direction using a drive mechanism (20, 21) after step (a); and
(c) fluidly suspending the test head (3) in a substantially weightless condition by maintaining a fluid pressure in the fluid compartment (23) positioned between the test head (3) and the drive mechanism (20,21).

15. The method of claim 14 further comprising a step of:
expanding and contracting the fluid compartment (23) using a piston (13) secured to the drive mechanism.

16. The method of claim 14 further comprising a step of:
applying an external force to adjust the desired position of the test head (3).

17. The method of claim 14 further comprising a step of:
providing air flow into the fluid compartment (23) such that the substantially weightless condition of the test head (3) is maintained.

18. The method of claim 14 further comprising a step of:
providing air flow out of the fluid compartment (23) such that the substantially weightless condition of the test head (3) is maintained.

## Patentansprüche

1. Positionierungsvorrichtung (1) zum Positionieren eines Testkopfes (3) zum Testen elektronischer Komponenten, wobei die Positionierungsvorrichtung (1) umfasst:
einen Antriebsmechanismus (20, 21) zum Bewegen des Testkopfes (3) in einer vertikalen Richtung; und
einen druckluftkonformen Kopplungsmechanismus (23), der mit dem Antriebsmechanismus (20, 21) gekoppelt ist, wobei der druckluftkonforme Kopplungsmechanismus (23) den Testkopf (3) in einem im Wesentlichen gewichtslosen Zustand unterstützt und einen Bewegungsbereich für den Testkopf (3) in der vertikalen Richtung schafft,
**dadurch gekennzeichnet, dass**
der druckluftkonforme Kopplungsmechanismus (23) über dem Antriebsmechanismus (20, 21) positioniert und an diesem befestigt ist, derart, dass der Antriebsmechanismus (20, 21) den druckluftkonformen Kopplungsmechanismus (23) bewegt, wenn er den Testkopf (3) in der vertikalen Richtung bewegt.

2. Positionierungsvorrichtung nach Anspruch 1, bei der der Antriebsmechanismus (20, 21) mit einem Gewinde versehen ist.

3. Positionierungsvorrichtung nach Anspruch 1 oder 2, bei der der druckluftkonforme Kopplungsmechanismus (20, 21) einen Fluidraum (23) und einen Druckregulierer, um in dem Fluidraum (23) einen Druck aufrecht zu erhalten, umfasst, derart, dass der Testkopf (3) in dem im Wesentlichen gewichtslosen Zustand aufgehängt werden kann.

4. Positionierungsvorrichtung nach Anspruch 1, die ferner umfasst:
einen Innenzylinder (7);
einen Außenzylinder (8), der über dem Innenzylinder (7) angeordnet ist, derart, dass er in einer Längsrichtung gleiten kann;
eine Trägerarmvorrichtung (2), die den Testkopf (3) trägt und an dem Außenzylinder (8) befestigt ist;
eine Hubvorrichtung (31) zum Anheben und Absenken des Außenzylinders (8);
einen Fluidhalteraum (23), der ein Teil des druckluftkonformen Kopplungsmechanismus ist, wobei der Fluidhalteraum (23) in dem Außenzylinder (8) vorgesehen ist; und
eine Druckerzeugungsvorrichtung (27), die über eine Fluidleitung (25) mit dem Fluidhalteraum (23) verbunden und so entworfen ist, dass sie eine Fluiddruckkraft erzeugt, die entgegengesetzt zu dem Gewicht des Testkopfes (3) und der Trägerarmvorrichtung (2) gerichtet ist, wobei
die Hubvorrichtung (31) einen Kolben (13) umfasst, der in dem Außenzylinder (8) angeordnet ist, wobei der Außenzylinder (8) in Bezug auf den Kolben (13) gleiten kann und der Druck in dem Fluidhalteraum (23) über eine Druckregulierungsvorrichtung (26) in der Weise reguliert werden kann, dass der Außenzylinder (8) zusammen mit der Trägerarmvorrichtung (2) und dem Testkopf (3) in eine aufgehängte Position gebracht werden kann, die in Bezug auf den Kolben (13) in der Höhe einstellbar ist.

5. Positionierungsvorrichtung nach Anspruch 4, bei der die Hubvorrichtung (31) eine Hubstange umfasst, die mittels eines Gewindeantriebsmechanismus in der Höhe einstellbar ist und den Kolben (13) am oberen Ende der Hebestange trägt.

6. Positionierungsvorrichtung nach einem der Ansprüche 4 oder 5, bei der die Hubvorrichtung (31) eine hohle Hubstange (14) umfasst, die über einen Gewindeantriebsmechanismus in der Höhe einstellbar ist, wobei der Gewindeantriebsmechanismus einen Gewindeantrieb besitzt, der in dem Innenzylinder (7), der in die hohle Hubstange (14) eingeführt ist, mittig angeordnet ist.

7. Positionierungsvorrichtung nach einem der Ansprüche 4 bis 6, bei der der Fluidhalteraum (23) am oberen Ende durch eine obere Stirnfläche des Außenzylinders (8) und am Boden durch den Kolben (13) begrenzt ist.

8. Positionierungsvorrichtung nach einem der Ansprüche 4 bis 7, bei der die Druckregulierungsvorrichtung einen Druckregulierer umfasst, um in der Fluidleitung, die zu dem Fluidhalteraum führt, einen konstanten Druck aufrecht zu erhalten, und bei der in der Fluidleitung ein 3/2-Wegeventil und ein Einweg-Restriktor vorgesehen und zueinander parallel geschaltet sind.

9. Positionierungsvorrichtung nach Anspruch 1, die ferner umfasst:
einen Außenzylinder (8);
einen Träger (2), der mit dem Außenzylinder (8) gekoppelt ist, um den Testkopf (3) zu tragen;
einen Kolben (13), der in dem Außenzylinder (8) angeordnet ist, wobei der Kolben (13) und der Außenzylinder (8) einen Fluidraum (23) definieren, der einen Teil des druckluftkonformen Kopplungsmechanismus in dem Außenzylinder (8) bildet;
einen Druckregulierer (28), um einen Druck in dem Fluidraum (23) aufrecht zu erhalten, derart, dass der Testkopf (3) in einer im Wesentlichen gewichtslosen Position aufgehängt werden kann, wobei diese Position in einer vertikalen Richtung einstellbar ist;
eine Hubvorrichtung (31) zum Anheben und Absenken des Außenzylinders (8), wobei die Hubvorrichtung (31) den mit dem Kolben (13) gekoppelten Antriebsmechanismus (20, 21) enthält; und
eine Antriebsvorrichtung (52), um den Antriebsmechanismus (20, 21) so zu betreiben, dass er den Testkopf (3) in eine vorgegebene Position bewegt.

10. Positionierungsvorrichtung nach Anspruch 9, bei der der Antriebsmechanismus (20, 21) ein Gewindeantriebsmechanismus ist.

11. Positionierungsvorrichtung nach Anspruch 10, bei der der Antriebsmechanismus (20, 21) ein Antriebsspindelmechanismus ist.

12. Positionierungsvorrichtung nach Anspruch 9, bei der der Fluidraum (23) über dem Antriebsmechanismus (20, 21) positioniert ist, derart, dass der Testkopf (3) dann, wenn der Antriebsmechanismus (20, 21) den Fluidraum (23) in einer vertikalen Richtung antreibt, ebenfalls in der vertikalen Richtung angetrieben wird.

13. Positionierungsvorrichtung nach Anspruch 9, die zusätzlich umfasst:
einen Positionssensor (50), um eine vertikale Position des Testkopfes (3) zu detektieren.

14. Verfahren zum Positionieren eines Testkopfes (3) zum Testen elektronischer Komponenten, wobei das Verfahren die folgenden Schritte umfasst:
(a) Bereitstellen einer Fluidströmung in einen Fluidraum (23), der mit dem Testkopf (3) gekoppelt ist;
(b) mechanisches Bewegen des Testkopfes (3) in eine gewünschte Position in einer vertikalen Richtung unter Verwendung eines Antriebsmechanismus (20, 21) nach dem Schritt (a); und
(c) fluidisches Aufhängen des Testkopfes (3) in einem im Wesentlichen gewichtslosen Zustand durch Aufrechterhalten eines Fluiddrucks in dem Fluidraum (23), der zwischen dem Testkopf (3) und dem Antriebsmechanismus (20, 21) positioniert ist.

15. Verfahren nach Anspruch 14, das ferner den folgenden Schritt umfasst:
Expandieren und Kontrahieren des Fluidraums (23) unter Verwendung eines Kolbens (13), der an dem Antriebsmechanismus befestigt ist.

16. Verfahren nach Anspruch 14, das ferner den folgenden Schritt umfasst:
Ausüben einer äußeren Kraft, um die gewünschte Position des Testkopfes (3) einzustellen.

17. Verfahren nach Anspruch 14, das ferner den folgenden Schritt umfasst:
Bereitstellen einer Luftströmung in den Fluidraum (23), derart, dass der im Wesentlichen gewichtslose Zustand des Testkopfes (3) aufrechterhalten wird.

18. Verfahren nach Anspruch 14, das ferner den folgenden Schritt umfasst:
Bereitstellen einer Luftströmung aus dem Fluidraum (23), derart, dass der im Wesentlichen gewichtslose Zustand des Testkopfes (3) aufrechterhalten wird.

## Revendications

1. Appareil de positionnement (1) pour positionner une tête (3) de test pour tester des composants électroniques, ledit appareil de positionnement (1) comprenant :
un mécanisme d'entraînement (20, 21) pour déplacer la tête (3) de test dans une direction verticale ; et
un mécanisme de couplage (23) souple pneumatique couplé audit mécanisme d'entraînement (20, 21), ledit mécanisme de couplage (23) souple pneumatique supportant la tête (3) de test dans une état sensiblement en impesanteur et fournissant une plage de déplacement vers la tête (3) de test dans la direction verticale,
**caractérisé en ce que**
ledit mécanisme de couplage (23) souple pneumatique est positionné au-dessus et fixé sur ledit mécanisme d'entraînement (20, 21), de sorte que ledit mécanisme d'entraînement (20, 21) déplace ledit mécanisme de couplage (23) souple pneumatique lorsqu'il déplace la tête (3) de test dans la direction verticale.

2. Appareil de positionnement selon la revendication 1 dans lequel ledit mécanisme d'entraînement (20, 21) est fileté.

3. Appareil de positionnement selon la revendication 1 ou 2 dans lequel ledit mécanisme de couplage (20, 21) souple pneumatique comporte un compartiment (23) de fluide et un régulateur de pression pour maintenir une pression à l'intérieur dudit compartiment (23) de fluide de sorte que la tête (3) de test peut être suspendue dans l'état sensiblement en impesanteur.

4. Appareil de positionnement selon la revendication 1 comprenant en outre :
un cylindre intérieur (7);
un cylindre extérieur (8) qui est placé sur le cylindre intérieur (7) de sorte qu'il peut être coulissé dans une direction longitudinale ;
un dispositif (2) de bras de support qui porte la tête (3) de test et est fixé au cylindre extérieur (8) ;
un appareil de levage (31) pour soulever et abaisser le cylindre extérieur (8) ;
un compartiment (23) de retenue du fluide faisant partie du mécanisme de couplage souple pneumatique, le compartiment (23) de retenue du fluide étant prévu à l'intérieur du cylindre extérieur (8) ; et
un dispositif (27) de génération de pression qui est relié via un circuit (25) de fluide au compartiment (23) de retenue du fluide et est conçu pour générer une force de pression du fluide dirigée contre le poids de la tête (3) de test et le dispositif (2) de bras de support, dans lequel
le dispositif (31) de levage comporte un piston (13) aménagé à l'intérieur du cylindre extérieur (8), le cylindre extérieur (8) peut coulisser par rapport au piston (13) et la pression dans le compartiment (23) de retenue du fluide peut être régulée via un dispositif (26) de régulation de pression de manière à ce que le cylindre extérieur (8), avec le dispositif (2) de bras de support et la tête (3) de test, puissent être amenés dans une position suspendue qui est réglable en hauteur par rapport au piston (13).

5. Appareil de positionnement selon la revendication 4, dans lequel le dispositif (31) de levage comprend une tige de levage qui peut être réglée en hauteur au moyen d'un mécanisme d'entraînement fileté et porte le piston (13) à une extrémité supérieure de la tige de levage.

6. Appareil de positionnement selon l'une ou l'autre des revendications 4 ou 5, dans lequel le dispositif (31) de levage comprend une tige (14) de levage creuse qui peut être réglée en hauteur via un mécanisme d'entraînement fileté, le mécanisme d'entraînement fileté ayant un entraînement fileté aménagé de manière centrale à l'intérieur du cylindre intérieur (7) qui est introduit dans la tige (14) de levage creuse.

7. Appareil de positionnement selon l'une quelconque des revendications 4 à 6, dans lequel le compartiment (23) de retenue du fluide est bordé dans la partie supérieure par une face d'extrémité supérieure du cylindre extérieur (8) et sur la partie inférieure par le piston (13).

8. Appareil de positionnement selon l'une quelconque des revendications 4 à 7, dans lequel le dispositif de régulation de pression comprend un régulateur de pression pour maintenir une pression constante dans le circuit de fluide menant au compartiment de retenue du fluide, et dans le circuit de fluide une soupape à 3/2 voies et un dispositif de restriction à une voie sont fournis et sont reliés en parallèle l'un avec l'autre.

9. Appareil de positionnement selon la revendication 1 comprenant en outre :
un cylindre extérieur (8);
un support (2) couplé audit cylindre extérieur (8) pour supporter la tête (3) de test ;
un piston (13) aménagé à l'intérieur dudit cylindre extérieur (8), ledit piston (13) et ledit cylindre extérieur (8) définissant un compartiment (23) de fluide faisant partie du mécanisme de couplage souple pneumatique à l'intérieur dudit cylindre extérieur (8) ;
un régulateur (28) de pression pour maintenir une pression à l'intérieur dudit compartiment (23) de fluide de sorte que la tête (3) de test peut être suspendue dans une position sensiblement en impesanteur, ladite position étant réglable dans une direction verticale ;
un dispositif (31) de levage pour soulever et abaisser ledit cylindre extérieur (8), ledit dispositif (31) de levage comportant le mécanisme d'entraînement (20, 21) couplé au piston (13) ; et
un appareil d'entraînement (52) pour faire fonctionner ledit mécanisme d'entraînement (20, 21) pour déplacer la tête (3) de test sur une position prédéterminée.

10. Appareil de positionnement selon la revendication 9, dans lequel ledit mécanisme d'entraînement (20, 21) est un mécanisme d'entraînement fileté.

11. Appareil de positionnement selon la revendication 10 dans lequel ledit mécanisme d'entraînement (20, 21) est un mécanisme à vis-mère.

12. Appareil de positionnement selon la revendication 9 dans lequel le compartiment (23) de fluide est positionné au-dessus dudit mécanisme d'entraînement (20, 21) de sorte que lorsque ledit mécanisme d'entraînement (20, 21) entraîne ledit compartiment (23) de fluide dans une direction verticale, la tête (3) de test soit aussi entraînée dans la direction verticale.

13. Appareil de positionnement selon la revendication 9 comprenant de plus : un capteur (50) de position pour détecter une position verticale de la tête (3) de test.

14. Procédé de positionnement d'une tête (3) de test pour tester des composants électroniques, ledit procédé comprenant les étapes consistant à :
(a) fournir l'écoulement d'un liquide dans un compartiment (23) de fluide couplé à la tête (3) de test ;
(b) déplacer mécaniquement la tête (3) de test dans une position souhaitée dans une direction verticale à l'aide d'un mécanisme d'entraînement (20, 21) après l'étape (a) ; et
(c) suspendre fluidiquement la tête (3) de test dans un état sensiblement en impesanteur en maintenant une pression de fluide dans le compartiment (23) de fluide situé entre la tête (23) de test et le mécanisme d'entraînement (20, 21).

15. Procédé selon la revendication 14 comprenant en outre une étape consistant à :
dilater et contracter le compartiment (23) de fluide à l'aide d'un piston (13) fixé sur le mécanisme d'entraînement.

16. Procédé selon la revendication 14 comprenant en outre une étape consistant à :
exercer une force externe pour ajuster la position souhaitée de la tête (3) de test.

17. Procédé selon la revendication 14 comprenant en outre une étape consistant à :
fournir un écoulement d'air dans le compartiment (23) de fluide de sorte que l'état sensiblement en impesanteur de la tête (3) de test soit maintenu.

18. Procédé selon la revendication 14 comprenant en outre une étape consistant à :
fournir un écoulement d'air hors du compartiment (23) de fluide de sorte que l'état sensiblement en impesanteur de la tête (3) de test soit maintenu.
